Europäisches Patentamt

European Patent Office

Office européen des brevets

(11) Veröffentlichungsnummer: **0 001 228**
**B1**

(12) # EUROPÄISCHE PATENTSCHRIFT

(45) Veröffentlichungstag der Patentschrift:
02.09.81

(51) Int. Cl.³: **H 01 J 37/147**

(21) Anmeldenummer: 78100779.4

(22) Anmeldetag: 29.08.78

(54) **Verbesserung an einer Vorrichtung zur Elektronenstrahleintastung.**

(30) Priorität: 26.09.77 DE 2743200

(43) Veröffentlichungstag der Anmeldung:
04.04.79 Patentblatt 79/7

(45) Bekanntmachung des Hinweises auf die Patenterteilung:
02.09.81 Patentblatt 81/35

(84) Benannte Vertragsstaaten:
FR GB NL

(56) Entgegenhaltungen:
DE-C-896 044
DE-C-910 944
FR-A-1 013 995
GB-A-612 434
ZEITSCHRIFT FÜR ANGEWANDTE PHYSIK
Band 27, Nr. 3, 1969, Berlin,
V. I. PETROV et al. »On an stroboscopic
lorentz microscopy«, Seiten 188 — 191

(73) Patentinhaber: SIEMENS AKTIENGESELLSCHAFT Berlin
und München, Postfach 22 02 61, D-8000 München 22 (DE)

(72) Erfinder: Feuerbaum, Hans-Peter, Germersheimer
Strasse 38, D-8000 München 80 (DE)

## Verbesserung an einer Vorrichtung zur Elektronenstrahleintastung

Die Erfindung betrifft eine Vorrichtung zur Elektronenstrahleintastung, wie sie im Oberbegriff des Patentanspruchs 1 angegeben ist.

Aus dem Stand der Technik ist es bekannt, eine Elektronenstrahleintastung bei einem Elektronenstrahlsystem eines Rasterelektronenmikroskops zu verwenden. Die eigentliche zur Elektronenstrahleintastung vorgesehene Einrichtung ist ein Ablenksystem, mit dem der Elektronenstrahl im Regelfall zwischen Kathode und Rasterablenkung über eine Lochblende hinweg abgelenkt wird bzw. in eine Lochblende hinein und aus dieser wieder heraus abgelenkt wird. Solch ein Ablenksystem ist vorzugsweise hinter der ersten Anode, d. h. hinter der Hauptbeschleunigungsstrecke (von der Kathode aus gesehen), in das Elektronenstrahlsystem eingebaut. Es befindet sich dabei wenigstens nahe dem Bereich der Strahlfokussierung.

Es ist übliche Praxis, mit einem Rasterelektronenmikroskop Potentialkontrastmessungen, insbesondere an integrierten Schaltungen der Halbleitertechnik, durchzuführen. Mit diesen Messungen lassen sich Potentialverläufe in beispielsweise Leiterbahnen elektronenoptisch aufnehmen, wobei besonderes Interesse an Potentialveränderungen bei sehr hohen Frequenzen und hochfrequenten Impulsströmen vorliegt. Da an sich die bei der Potentialkontrastmessung mit Elektronenstrahl ausgenutzte Auswertung der Sekundärelektronen-Emission zumindest nicht geeignet ist, sehr rasche Vorgänge, z. B. mit $10^7$ bis $10^9$ Hz, zeitgetreu aufzunehmen, hat man das sog. Stroboskop-Prinzip angewendet, das aus der Hochfrequenzmeßtechnik unter dem Begriff »sampling« bekannt ist. Es erfolgt dabei ein mehrfaches korreliertes Abtasten einer gewünschten Stelle, deren Potentialkontrast festgestellt werden soll. Dieses stroboskopische Abtasten wird dann mit etwas Phasenverschiebung wiederholt, so daß nach Art eines sampling-Verfahrens der ganze, sehr hochfrequente Potentialverlauf festgestellt werden kann, obwohl in der Meßeinrichtung ein relativer Zeitträgereffekt, nämlich im Zusammenhang mit der Sekundär-Emission und dem Einfangen der Sekundärelektronen, beteiligt ist.

Dieses Stroboskop- oder sampling-Verfahren erfordert, daß äußerst kurze Elektronenstrahlimpulse im Rasterelektronenmikroskop erzeugt werden, deren Phase dann zudem noch vergleichsweise zum Wechselstromsignal in der zu untersuchenden Probe zu verschieben ist. Diese Phasenverschiebung läuft auf eine Verschiebung des Impulszeitpunktes des Elektronenstrahls hinaus.

Derart kurze Elektronenstrahlimpulse werden gemäß bekannter Praxis unter Verwendung einer Lochblende und einer solchen Strahl-Ablenkeinrichtung verwirklicht, die im Grunde genommen zwei einander gegenüberstehende, sich in Axialrichtung des Elektronenstrahls erstreckende Elemente eines Ablenkkondensators hat, wobei jedoch einer Ablenkplatte eine Einrichtung gegenübersteht, die eine Wanderwelleneinrichtung mit Interdigitalstruktur ist. In dieser Interdigitalstruktur läuft die Welle des Ablenksignals, mit dem diese impulstastende Ablenkeinrichtung zu beaufschlagen ist, mit gleicher Geschwindigkeit wie die durch diesen Ablenkkondensator hindurchlaufenden Strahlelektronen. Bei einer Interdigitalstruktur im Sinne der Erfindung handelt es sich um eine mit dem Signal zu beaufschlagenden Fingerleitung, die mit einer zweiten auf Masse liegenden Fingerleitung kämmt.

Zum voranstehenden können weitere Einzelheiten den Druckschriften IEEE Transactions and Electron Devices, Bd. ED-19, Nr. 2 (1972) S. 204−213 und Scanning Electron Microscopy (1973) (Part I), Proc. of the Sixth Annual Scanning Electron Microscop Symposium, IIT Research Institute, Chicago, Illinois 60616 USA (April 73) und Scanning Electron Microcopy (1976) (Part IV), Proc. of the Workshop on Microelectronic Device Fabrication and Quality Control with SEM, IIT Research Institute (April 1976) entnommen werden. Insbesondere ist in Fig. 1 der erstgenannten Druckschrift IEEE ... eine solche Mäanderleitung mit Interdigitalstruktur gezeigt. Aus diesen genannten Druckschriften geht auch die Betriebsweise eines wie bekannten Rasterelektronenmikroskops bzw. der in dessen Elektronenstrahlsystem befindlichen Ablenkeinrichtung mit Wanderwelle hervor.

Ein Nachteil einer wie bekannten Ablenkeinrichtung ist, daß das zwischen der Mäanderstruktur und der gegenüberliegenden Elektrode herrschende, zur Elektronenstrahlachse transversale Ablenkfeld zwangsläufig auch eine longitudinale elektrische Feldkomponente hat, die somit eine Beschleunigung oder Verzögerung des Elektronenstrahls bewirkt. Dies führt zu einer im Betrieb bei Veränderung des elektrischen Ablenksignals in der Ablenkeinrichtung auftretenden Defokussierung des auf die zu untersuchende Probe an sich äußerst scharf fokussierten Elektronenstrahls.

Aus der erstgenannten Druckschrift IEEE Transactions ... ist ein symmetrisches Ablenksystem mit zwei Wendelverzögerungsleitungen bekannt, an welche Signale gleicher Amplitude und entgegengesetzten Vorzeichens angelegt werden. Ein solches symmetrisches Ablenkungssystem kann jedoch nur für eine Grenzfrequenz von etwa 500 MHz erlangt werden.

Der vorliegenden Erfindung liegt die Aufgabe zugrunde, eine Vorrichtung der eingangs genannten Art anzugeben, mit der eine wesentlich höhere Grenzfrequenz und eine wesentlich kürzere Strahlimpulsbreite als nach dem Stand der Technik erzielt werden können, wobei eine Defokussierung des auf die zu untersuchende Probe an sich äußerst scharf fokussierten Elektronenstrahls praktisch nicht auftritt.

Diese Aufgabe wird bei einer wie im Oberbegriff des Patentanspruchs 1 angegebenen Vorrichtung erfindungsgemäß gelöst, wie dies im Kennzeichen des Patentanspruchs 1 angegeben ist, und weitere Ausgestaltungen und Weiterbildungen der Erfindung gehen aus den Unteransprüchen hervor.

Bei der Erfindung passieren auch Impulse, die nicht sinusförmig sind, unverzerrt das Ablenksystem. Bei der Erfindung bleibt der Elektronenstrahl auch bei sehr hochfrequenter Ablenkung aus seiner zentralen Lage in der Bohrung der Lochblende weiterhin scharf fokussiert.

Weitere Erläuterungen der Erfindung gehen aus der nachfolgenden Beschreibung eines Ausführungsbeispiels hervor.

Fig. 1 zeigt eine wie erfindungsgemäße Ablenkeinrichtung in einem Ablenksystem.

Fig. 2 zeigt eine Ablenkeinrichtung in Einzelheiten.

Fig. 3 zeigt die Superposition der Potentiale.

Fig. 4 und 5 zeigen ein Beispiel zur Impulserzeugung.

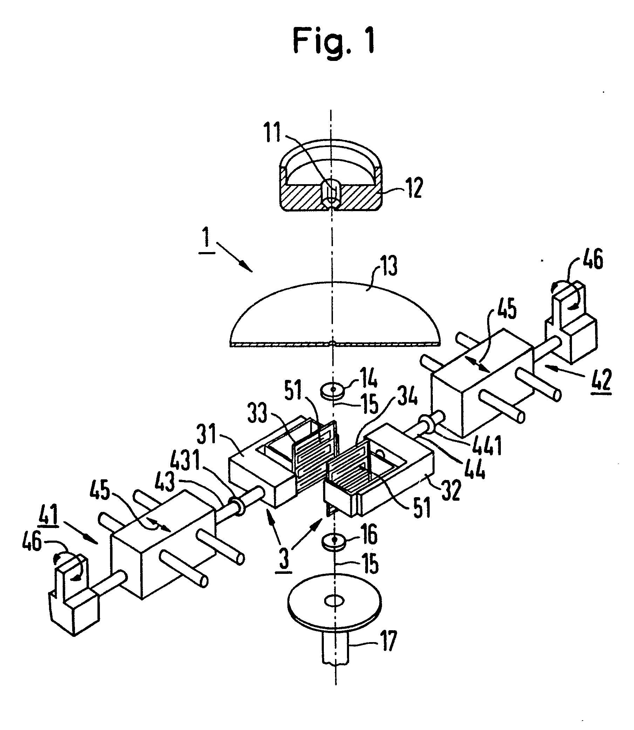

Fig. 1 zeigt eine wie erfindungsgemäße Ablenkeinrichtung in einem Ablenksystem 3 in einem Elektronenstrahlgerät 1. Mit 11 ist die Kathode, mit 12 die Wehnelt-Elektrode und mit 13 die als Lochscheibe ausgebildete Anode bezeichnet. Eine erste Lochblende ist mit 14 bezeichnet. Diese hat eine Öffnung von z. B. 100 μm Durchmesser. Der Elektronenstrahl 15 geht von der Kathode 11 durch das Loch der Anode 13 und die Lochblende 14 hindurch. Er geht dann weiter durch das Ablenksystem 3 und bei fehlender Ablenkung durch eine zweite Lochblende 16 hindurch, die eine Bohrung von z. B. 300 μm Durchmesser hat. Weiter tritt der Elektronenstrahl 15 dann in das Innere eines Vakuumrohres 17 ein, in dem er dann z. B. für eine Rasterabtastung eine weitere Ablenkung, etwa mit Hilfe nicht dargestellter magnetischer Ablenkeinrichtungen (wie von Fernsehbildröhren her bekannt) erfährt. Die Teile 11 bis 16 und das Ablenksystem 3 befinden sich zusammen im Innern eines vakuumdichten Gehäuses, das der Übersichtlichkeit halber in der Fig. 1 nicht dargestellt ist.

Die Ablenkeinrichtung 3 hat zwei Ablenkteile 31 und 32, die Träger der eigentlichen Ablenkplatten 33 und 34 sind. Zur Justierung der Ablenkteile 31 und 32 und damit auch der Platten 33 und 34 sind Einrichtungen 41 und 42 vorgesehen, mit denen die Teile 31 und 32 über Wellen 43 bzw. 44 verbunden sind. Mit 431 und 441 sind Dichtungsringe bezeichnet, womit erkennbar ist, daß sich die Justiereinrichtungen 41 und 42 außerhalb des oben erwähnten, nicht dargestellten vakuumdichten Gehäuses befinden. Wie mit den Doppelpfeilen 45 und 46 angedeutet, lassen sich mit den einzelnen Bestandteilen der Justiereinrichtungen 41 und 42 seitliche und winkelmäßige Verschiebungen der Ablenkteile 31 und 32, bezogen auf die Strahlachse 15 im Innern des Vakuumgehäuses, vornehmen.

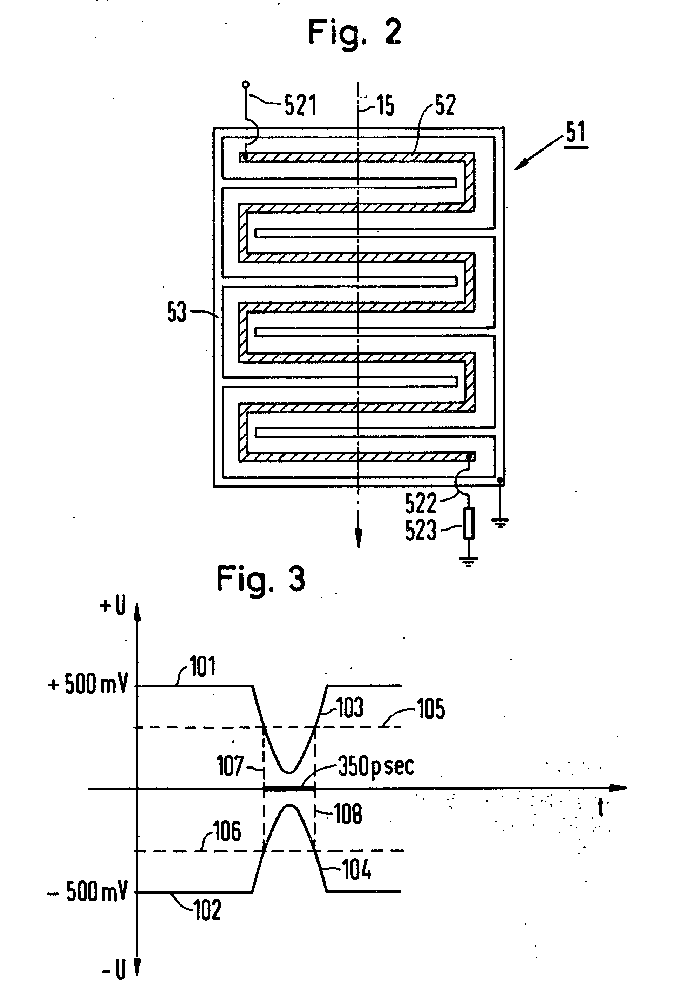

Die oben als Platten bezeichneten Teile 33 und 34 haben, wie dies besser aus der Fig. 2 in einer Aufsicht einer solchen Platte 33 zu ersehen ist, eine Interdigitalstruktur 51. Diese besteht aus einem mäanderförmigen Leiterbahnzug 52 und einer mit 53 bezeichneten Abschirm-Leiterbahnstruktur. Die Struktur 53 liegt, wie schematisch dargestellt, auf Masse. Die Leiterbahnstruktur 52 hat einen wie schematisch angedeuteten Eingangsanschluß 521 und einen Ausgangsanschluß 522, der über einen Anschlußwiderstand 523 ebenfalls an Masse liegt. Ein über den Eingang 521 in die Leiterbahnstruktur 52 gelangendes Hochfrequenzsignal verläuft dort entsprechend der mäanderförmigen Wegstrecke in der mit dem Pfeil 15 dargestellten Richtung gesehen entsprechend der Wegverlängerung verzögert. Diese Arbeitsweise einer Interdigitalstruktur 51 ist für den Fachmann hinlänglich bekannt und der Pfeil 15 der Fig. 2 ist identisch mit der in Fig. 1 angegebenen Strahlachse bzw. mit dem dort eingezeichneten Elektronenstrahl 15. Die mit 53 bezeichnete Struktur dient mit ihren in die Mäander der Struktur 52 eingreifenden Finger der Vermeidung von Dispersionseigenschaften, wie dies an sich im Prinzip bekannt ist. Die Bemessung einer Interdigitalstruktur 51 hängt in an sich bekannter Weise von der Strahlgeschwindigkeit, d. h. der Beschleunigungsspannung, des Elektronenstrahls 51 in ebenfalls bekannter Weise ab. Die Interdigitalstruktur 51 kann eine freitragend aufgebaute oder auch auf eine Platte aus dielektrischem Material aufgebrachte Leiterbahnstruktur sein. Beide Ablenkteile 31 und 32 haben erfindungsgemäß identische Interdigitalstrukturen 51 an der Stelle der erwähnten Platten 33 und 34.

Wie dies in der Fig. 1 der Übersichtlichkeit halber an sich nicht dargestellt ist, werden den Interdigitalstrukturen 51 der beiden Platten 33 und 34 an den Anschlüssen 521 Ablenksignale zugeführt, die einander entgegengesetzte Polarität in den beiden einander gegenüberstehenden Interdigitalstrukturen haben. Diese der Erfindung gemäße Maßnahme bewirkt, daß selbst bei Vorhandensein von von Null verschiedenen Potentialen in den einander gegenüberliegenden Interdigitalstrukturen 51 das Potential in der Strahlachse 15 zumindest aus diesen dem Ablenksystem 3 zugeführten Signalen keine Feldkomponente in longitudinaler Richtung erfährt. Von den Signalen auf den einander gegenüberstehenden Interdigitalstrukturen 51 werden nur transversale Felder auf den Elektronenstrahl 15 wirksam, und zwar mit den Elektronen des Elektronenstrahls 15 mit gleicher Geschwindigkeit laufend. Der Synchronismus zwischen Elektronenstrahl und Ablenksignal auf dem Mäander der Leiterbahnstruktur 52 bewirkt über die Länge der Platten 33 und 34 hinweg eine dauernd gleichbleibende Ablenkeinwirkung auf die sich synchron im Elektronenstrahl fortbewegenden Elektronen.

Ab einer bestimmten Ablenkspannung zwi-

schen den einander gegenüberliegenden Interdigitalstrukturen 52 erfahren die Elektronen des Elektronenstrahles 15 dann eine derart große Ablenkung, daß sie nicht mehr durch die Öffnung der Lochblende 16 hindurchtreten und somit aus dem Elektronenstrahl ausgeblendet sind. Mit der Erfindung ist sichergestellt, daß Elektronen, die eine Ablenkung erfahren, durch die sie noch nicht ausgeblendet werden, zumindest keine longitudinale Beschleunigung erfahren, die zu einer wie beim Stand der Technik als störend festgestellten Defokussierung am Zielort führen kann.

Fig. 3 zeigt schematisch in einem Schaubild die beiden Signalspannungen 61 und 62, die an die jeweiligen Eingangsanschlüsse 521 der Interdigitalstrukturen 51 der beiden Ablenkteile 33 und 34 zur Strahleintastung anzulegen sind.

Auf der Abszisse der Fig. 3 ist die Zeit aufgetragen. Auf der Ordinate ist nach oben das positive Potential der einen der beiden Interdigitalstrukturen 51 und nach unten das negative Potential der gegenüberliegenden anderen Interdigitalstruktur 51 aufgetragen. Bei der hier vorgesehenen Elektronenstrahleintastung ist es der Normalfall, daß der Elektronenstrahl ausgetastet ist, d. h. derart abgelenkt ist, daß er nicht durch die in Fig. 1 dargestellte Lochblende 16 hindurchtreten kann. Erst im eingetasteten Zustand verläuft der Elektronenstrahl auf der in Fig. 1 dargestellten Strahlachse 15 und damit durch diese Lochblende 16 hindurch. Während der Zeit, während der der Elektronenstrahl ausgetastet ist, liegen an den beiden gegenüberliegenden Platten 33 und 34 bzw. an den beiden gegenüberliegenden Interdigitalstrukturen 51 entgegengesetzte, mit 101 und 102 bezeichnete Gleichspannungspotential an, die ein quergerichtetes elektrisches Ablenkfeld auf den Elektronenstrahl einwirken lassen. Mit 103 und 104 sind Impulse einander entgegengesetzter Polarität in der Form von Sinushalbwellen bezeichnet, die die erwähnten Ablenksignale mit zueinander entgegengesetztem Vorzeichen sind. Mit den gestrichelten Linien 105 und 106 sind zwei Potentialwerte bezeichnet, die die Schwelle für die Elektronenstrahleintastung angeben. Die senkrechten gestrichelten Linien 107 und 108 schließen den zeitlichen Bereich der Elektronenstrahleinrichtung ein, der z. B. eine Länge von 350 psec hat. Es ist aus der Fig. 3 erkennbar, daß über beträchtliche Zeitanteile hinweg während der Eintastung des Elektronenstrahles noch ein Querfeld auf die Elektronen einwirkt. Erfindungsgemäß wirkt auf diese Elektronen aber in dieser Zeit kein Longitudinalfeld ein, das — wie dies der Erfinder erkannt hat — zu den Mängeln bei entsprechenden Vorrichtungen des Standes der Technik geführt hat.

Der Vollständigkeit halber sei darauf hingewiesen, daß für die Eintastung des Elektronenstrahles nicht in jedem Falle eine wie mit 16 bezeichnete Lochblende erforderlich ist. Der während der Zeiten des Elektronenstrahles vorliegende Elektronenstrahlstrom kann anstatt auf eine Blende 16 auch auf die Platten der Ablenkeinrichtung (aus der Strahlachse) weggelenkt werden, denn ebenso wie bei bekannten entsprechenden Vorrichtungen ist auch bei der erfindungsgemäßen Vorrichtung vorgesehen, daß die einander gegenüberstehenden Platten 33 und 34 bzw. die einander gegenüberstehenden Interdigitalstrukturen 51 nur einen geringen Abstand voneinander haben und gerade genügend Raum dazwischen verbleibt, um den Elektronenstrahl (bei Elektronenstrahleintastung) ungehindert hindurchzulassen.

Mit einer erfindungsgemäßen Vorrichtung zur Elektronenstrahleintastung läßt sich über die obige Problemlösung hinausgehend eine extrem kurzzeitige Strahlimpulstastung mit wiederholbar exaktem Impulsanfang und -ende durchführen. Dazu werden gemäß einer Weiterbildung der Erfindung an die beiden symmetrisch zur Strahlachse angeordneten Ablenkteile des Ablenksystems Impulse mit steilen Flanken, jedoch nicht notwendigerweise kurzer Impulsbreite angelegt. Der an das eine Ablenkteil angelegte Impuls ist aber gegenüber dem an das gegenüberliegende Ablenkteil angelegten anderen Impuls zeitlich derart verschoben, daß nur eine zeitlich geringe Überlappung der beiden Impulse (gesehen im Zeitdiagramm) vorliegt.

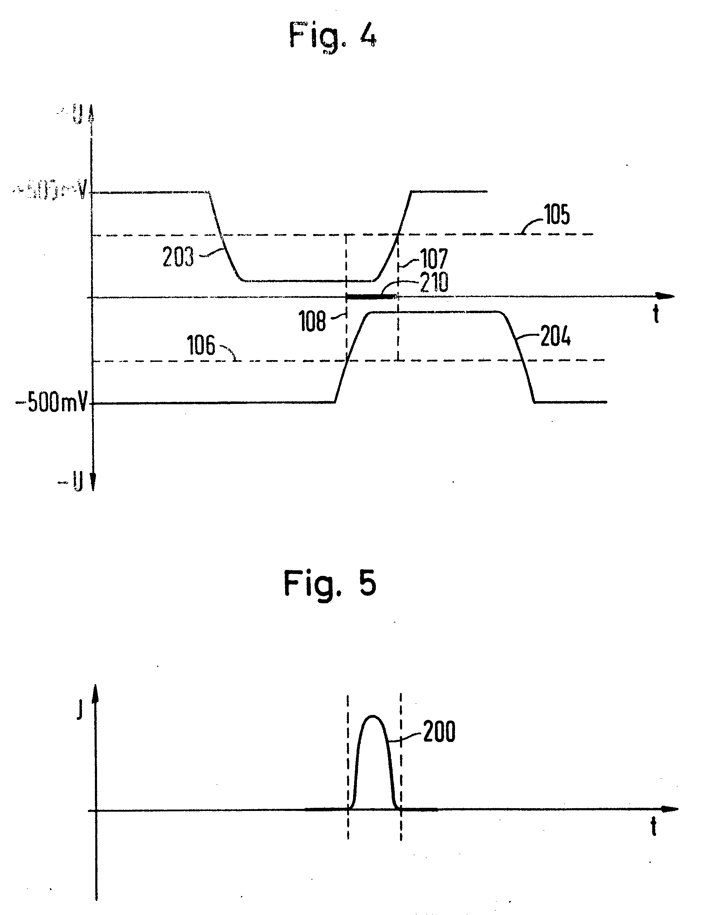

Die Fig. 4 und 5 zeigen die vorangehend geschilderten Verhältnisse in leicht verständlicher Form. Im allgemeinen stimmen die Einzelheiten der Darstellung der Fig. 4 mit denjenigen der Fig. 3 überein. Jedoch sind die Impulse 203 und 204, die an den jeweils einander gegenüberstehenden Ablenkteilen 33, 34 anliegen, wie ersichtlich zeitlich verschoben. Es liegt nur ein relativ kurzes Zeitintervall 210 vor, während dem beide Impulse 203 und 204 gegeneinander eine solche Potentialdifferenz haben, daß der Strahl 15 die Einrichtung ohne Strahlablenkung, z. B. die Blende 16, axial und ohne Defokussierung durchsetzt. Während dieses Zeitintervalles tritt der in Fig. 5 dargestellte, relativ kurze Strahlimpuls 200 auf. Seine Flanken hängen sowohl von den Flanken der Impulse 203 und 204 als auch von der Steuerempfindlichkeit der erfindungsgemäßen Einrichtung ab. Für eine kurze Impulsbreite sind vorteilhafterweise keine vergleichbar kurzen Impulse erforderlich, sondern es genügen Impulse wie dargestellter vergleichsweise erheblich größerer Breite. Solche Impulse lassen sich aber in einfacher Weise erzeugen.

Legt man jedoch mit Fig. 3 vergleichbar kurze Impulse an die Ablenkteile an, ergibt sich ein entsprechend extrem kurzer Impuls.

Für weitere Einzelheiten der Fig. 4 sei auf die Beschreibung zur Fig. 3 verwiesen.

**Patentansprüche**

1. Vorrichtung zur Elektronenstrahleintastung für ein Elektronenstrahlsystem, geeignet für ein Rasterelektronenmikroskop, eine Elektronenstrahlschreibvorrichtung und dergl., mit einem Ablenksystem zur zeitlich steuerbaren Ablenkung des Elektronenstrahles aus seiner vorgesehenen Strahlachse zur Strahlaustastung, wobei das Ablenksystem eine Ablenkeinrichtung mit zur Strahlgeschwindigkeit angepaßter Laufzeitwirkung für das Ablenksignal hat, dadurch gekennzeichnet, daß die Ablenkeinrichtung (31, 32) bezogen auf die Strahlachse (15) zueinander symmetrische Wanderwelleneinrichtungen mit Interdigitalstruktur (33, 34, 51) hat, an die Ablenksignale mit jeweils zueinander entgegengesetztem Vorzeichen anzulegen sind, so daß auch bei Strahlablenkung gleichbleibendes axiales Potential vorliegt.

2. Vorrichtung nach Anspruch 1, dadurch gekennzeichnet, daß in der Strahlachse eine Lochblende (16) angeordnet ist.

3. Betrieb einer Vorrichtung zur Elektronenstrahleintastung nach Anspruch 1 oder 2, gekennzeichnet dadurch, daß für eine kurzzeitige Elektronenstrahleintastung unter Verwendung vergleichsweise breiter Impulse an die Ablenkeinrichtung (31, 32) gegeneinander zeitlich verschobene Impulse angelegt werden, die zeitlich um nur ein geringes Maß überlappen (Fig. 4).

## Claims

1. A device for electron-beam keying for an electron-beam system, suitable for a scanning electron microscope, an electron-beam recording device and the like, comprising a deflecting system for the time-controllable deflection of the electron beam from its provided beam axis for beam suppression, wherein the deflecting system possesses a deflecting device having a transit time effect, which is adapted to the beam velocity, for the deflecting signal, characterised in that the deflecting device (31, 32) has travelling-wave structures with an interdigitated structure (33, 34, 51) which are mutually symmetrical relative to the beam axis, and to which deflecting signals of mutually opposite sign are applied, so that a constant axial potential is present, even in the case of beam deflection.

2. A device as claimed in Claim 1, characterised in that a diaphragm (16) is arranged on the beam axis.

3. Operation of a device for electron-beam keying as claimed in Claim 1 or Claim 2, characterised in that there are applied to the deflecting device for short-time keying of an electron-beam comparatively wide pulses that are time-delayed such that they mutually overlap only to a small extent in the deflecting device (31, 32).

## Revendications

1. Dispositif pour l'alignement d'un rayon électronique sur un diaphragme pour un système à rayon électronique, approprié pour un microscope électronique à balayage pour un dispositif traçant à rayon électronique et autres dispositifs semblables, du type à systéme de déviation pour la déviation contrôlée dans le temps du rayon électronique hors de son axe prévue en vue d'une dispersion du rayon électronique, le système de déviation présentant un dispositif de déviation à effet de temps de propagation adapté à la vitesse dudit rayon pour le signal de déviation, caractérisé par le fait que le dispositif de déviation (31, 32), rapporté à l'axe du rayon (15), possède deux dispositifs à ondes progressives symétriques entre eux et présentant une structure interdigitée (33, 34, 51), auxquels sont appliqués les signaux de déviation de signes opposés, en sorte que même dans le cas d'une déviation du rayon, le potentiel axial est invariable.

2. Dispositif selon la revendication 1, caractérisé par le fait qu'un diaphragme à petite ouverture (16) est disposé dans l'axe du rayon électronique.

3. Procédé pour la mise en oeuvre d'un dispositif pour l'alignement d'un rayon électronique sur un diaphragme selon la revendication 1 ou 2, caractérisé par le fait que pour un alignement de courte durée sur le diaphragme, avec utilisation d'impulsions relativement larges, on applique au dispositif de déviation (31, 32) des impulsions décalées entre elles dans le temps et qui ne se recourvrent que pour un temps de faible durée (figure 4).

# Fig. 1

# Fig. 2

# Fig. 3

# Fig. 4

# Fig. 5